(19) Europäisches Patentamt / European Patent Office / Office européen des brevets

(11) **EP 3 341 985 B1**

(12) **FASCICULE DE BREVET EUROPEEN**

(45) Date de publication et mention de la délivrance du brevet:
**04.05.2022 Bulletin 2022/18**

(21) Numéro de dépôt: **16763922.8**

(22) Date de dépôt: **24.08.2016**

(51) Classification Internationale des Brevets (IPC):
**G01R 31/36** *(2020.01)*    **H01M 10/42** *(2006.01)*

(52) Classification Coopérative des Brevets (CPC):
**H01M 10/482; G01R 31/396; H01M 10/425;**
H01M 2010/4278; Y02E 60/10

(86) Numéro de dépôt international:
**PCT/FR2016/052110**

(87) Numéro de publication internationale:
**WO 2017/032949 (02.03.2017 Gazette 2017/09)**

(54) **BATTERIE ASSURANT UNE DETERMINATION DE LA TENSION ELECTRIQUE AUX BORNES DES ELEMENTS DE CONNEXION ELECTRIQUE ENTRE LES ELEMENTS DE STOCKAGE**

BATTERIE ZUR SICHERSTELLUNG DER BESTIMMUNG DER ELEKTRISCHEN SPANNUNG DER ANSCHLÜSSE DER ELEKTRISCHEN VERBINDUNGSELEMENTE ZWISCHEN DEN SPEICHERELEMENTEN

BATTERY ENSURING DETERMINATION OF THE ELECTRICAL VOLTAGE ACROSS THE TERMINALS OF THE ELECTRICAL CONNECTION ELEMENTS BETWEEN THE STORAGE ELEMENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.08.2015 FR 1557922**

(43) Date de publication de la demande:
**04.07.2018 Bulletin 2018/27**

(73) Titulaire: **Renault s.a.s**
**92100 Boulogne Billancourt (FR)**

(72) Inventeurs:
• **RIVET, Sophie**
**Guyancourt 78280 (FR)**
• **LAVABRE, Marc**
**92420 Vaucresson (FR)**
• **GAGNE, Jean-Baptiste**
**08200 Sedan (FR)**
• **PALMIERI, Michael**
**38160 Gieres (FR)**
• **DERBEY, Alexis**
**38420 Revel (FR)**

(74) Mandataire: **Renault Group**
**Renault s.a.s.**
**API : TCR GRA 2 36**
**1, Avenue du Golf**
**78084 Guyancourt Cedex (FR)**

(56) Documents cités:
DE-A1-102011 081 573    FR-A1- 2 740 264
FR-A1- 2 940 547    FR-A1- 3 017 001
US-A1- 2012 237 807

**Description**

**Domaine technique de l'invention**

L'invention concerne une batterie de stockage d'énergie électrique, comprenant d'une part au moins des premier et deuxième éléments de stockage électriquement connectés en série entre eux par un élément de connexion électrique, d'autre part au moins des première et deuxième cartes électroniques de contrôle pilotant respectivement les premier et deuxième éléments de stockage et communiquant entre elles par une liaison de communication de données de la batterie.

**État de la technique**

Une batterie de stockage d'énergie électrique comprend une pluralité d'éléments de stockage électriquement connectés en série entre eux. Chaque élément de stockage est constitué par une cellule électrochimique ou un module comprenant une pluralité de cellules électrochimiques assemblées entre elles. Les cellules et/ou les modules sont organisés individuellement et assemblés deux à deux selon de préférence un montage en série de sorte à atteindre un niveau de tension demandé par l'application recherchée pour la batterie.

Deux éléments de stockage sont classiquement connectés entre eux par un élément de connexion électrique connu sous la dénomination anglo-saxonne « busbar », formé dans un matériau électriquement conducteur.

Cet élément de connexion électrique est fixé, par exemple par vissage, tout en assurant une conduction électrique à l'emplacement de la fixation, aux deux bornes des deux éléments de stockage reliés entre eux par cet élément de connexion électrique.

Une problématique repose sur le fait qu'en cas de défaut au niveau de la fixation entre une borne et l'élément de connexion électrique, la résistance électrique de la fixation augmente et est susceptible de provoquer un échauffement dangereux pour l'élément de stockage.

Une solution connue consiste à mesurer la tension électrique aux bornes des busbars, en mesurant l'écart entre la borne positive d'un élément de stockage et la borne négative de l'élément de stockage suivant du montage en série. Elle peut toutefois être onéreuse en raison de l'utilisation d'au moins un fil additionnel et d'un fusible électrique de protection de ce fil, et être complexe à assembler.

Il est connu d'équiper la batterie d'un système de gestion, aussi connu sous le nom de « BMS » pour « Battery Management System » en terminologie anglo-saxonne, comprenant une pluralité de cartes électroniques de contrôle. Il peut être prévu que chaque carte électronique, qui comprend classiquement un microcontrôleur, soit associée à un élément de stockage donné, par exemple afin de surveiller la tension électrique aux bornes de l'élément de stockage associé. La communication entre les cartes électroniques, qui est un flux numérique, se pratique par l'intermédiaire d'une liaison de communication de données.

Le document US2012237807A1 divulgue une batterie constituée de plusieurs cellules connectées en série par des busbars. Des calculateurs esclaves reçoivent des courants de mesure pris aux bornes de plusieurs cellules adjacentes, et donc de leurs busbars respectifs, via un fil et un terminal de connexion annulaire. Les calculateurs renvoient des informations à un calculateur maître. Cette solution vise à résoudre les problèmes liés au risque de desserrage de la vis de fixation du busbar sur le terminal de connexion et liés au risque de variation de la résistance de contact des busbars. La solution propose un dispositif mécanique ayant une structure particulière qui tente de fiabiliser le contact mais elle ne permet pas de détecter toute altération du contact et d'éviter les risques de détérioration des éléments de stockage reliés par les busbars.

La demande de brevet FR 2 940 547 A1 divulgue un système de gestion électronique d'une batterie modulaire rechargeable et son procédé de gestion, qui présentent des inconvénients similaires.

**Objet de l'invention**

Le but de la présente invention est de proposer une batterie de stockage d'énergie électrique qui remédie aux inconvénients listés ci-dessus.

Un objet de l'invention est de fournir une telle batterie qui :

- permette de détecter un problème de fixation d'un élément de connexion électrique qui relie deux éléments de stockage dans leur montage en série,
- permette de détecter une augmentation de résistance électrique au niveau de la fixation de l'élément de connexion électrique sur une borne d'un élément de stockage,
- permette de mesurer la tension électrique de l'élément de connexion électrique qui relie les éléments de stockage,
- soit simple, peu onéreuse, sans difficulté d'assemblage, ergonomique.

**EP 3 341 985 B1**

Dans ce dessein, l'invention concerne une batterie de stockage d'énergie électrique, comprenant d'une part au moins des premier et deuxième éléments de stockage électriquement connectés en série entre eux par un élément de connexion électrique, d'autre part au moins des première et deuxième cartes électroniques de contrôle pilotant respectivement les premier et deuxième éléments de stockage et communiquant entre elles par une liaison de communication de données, la première carte électronique de contrôle étant configurée pour transmettre à la deuxième carte électronique de contrôle, par l'intermédiaire de la liaison de communication de données, une information permettant à la deuxième carte électronique de contrôle de déterminer le potentiel électrique du point de connexion entre l'élément de connexion électrique et le premier élément de stockage, de manière à déduire la tension électrique aux bornes de l'élément de connexion électrique, entre d'une part le point de connexion entre l'élément de connexion électrique et le premier élément de stockage et d'autre part le point de connexion entre l'élément de connexion électrique et le deuxième élément de stockage.

Dans d'autres modes de réalisation :

- la batterie comporte au moins un commutateur variant entre des première et deuxième positions distinctes établissant respectivement des niveaux de tension haut et bas d'un signal électrique circulant dans la liaison de communication de données et en ce que dans l'une des première et deuxième positions du commutateur, le niveau de tension reçu par une entrée d'un microcontrôleur de la deuxième carte électronique de contrôle dépend du potentiel électrique du point de connexion entre l'élément de connexion électrique et le premier élément de stockage ;
- le commutateur appartient à la première carte électronique de contrôle ;
- l'information qui permet à la deuxième carte électronique de contrôle de déterminer le potentiel électrique du point de connexion entre l'élément de connexion électrique et le premier élément de stockage correspond au niveau de tension reçu par l'entrée du microcontrôleur de la deuxième carte électronique de contrôle dans la première position du commutateur, ledit niveau de tension étant égal au niveau bas de tension du signal électrique circulant dans la liaison de communication de données ;
- l'information qui permet à la deuxième carte électronique de contrôle de déterminer le potentiel électrique du point de connexion entre l'élément de connexion électrique et le premier élément de stockage correspond au niveau de tension reçu par l'entrée du microcontrôleur de la deuxième carte électronique de contrôle dans la deuxième position du commutateur, ledit niveau de tension étant égal au niveau haut de tension du signal électrique circulant dans la liaison de communication de données ;
- les première et deuxième cartes électroniques de contrôle appartiennent à un système de gestion de la batterie de type maître-esclaves où les première et deuxième cartes électroniques de contrôle sont deux dispositifs esclaves qui communiquent avec un dispositif maître, la communication entre les première et deuxième cartes électroniques de contrôle étant unidirectionnelle en allant de la première carte électronique de contrôle vers la deuxième carte électronique de contrôle, et
- la batterie comprend un élément permettant d'émettre un signal d'alerte dans le cas où ladite tension électrique est supérieure à une valeur seuil prédéterminée et enregistrée dans une mémoire.

**Description sommaire des dessins**

D'autres avantages et caractéristiques ressortiront plus clairement de la description qui va suivre de modes particuliers de réalisation de l'invention donnés à titre d'exemples non limitatifs et représentés sur les dessins annexés, dans lesquels :

- la figure 1 est un schéma de principe au niveau de deux éléments de stockage d'un premier exemple de batterie de stockage d'énergie selon l'invention,
- la figure 2 est un schéma de principe au niveau de deux éléments de stockage d'un deuxième exemple de batterie de stockage d'énergie selon l'invention.

**Description de modes préférentiels de l'invention**

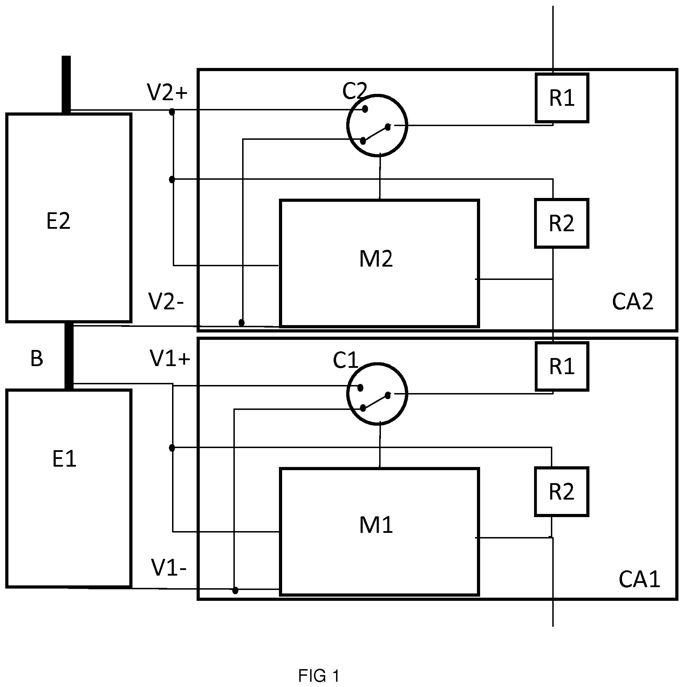

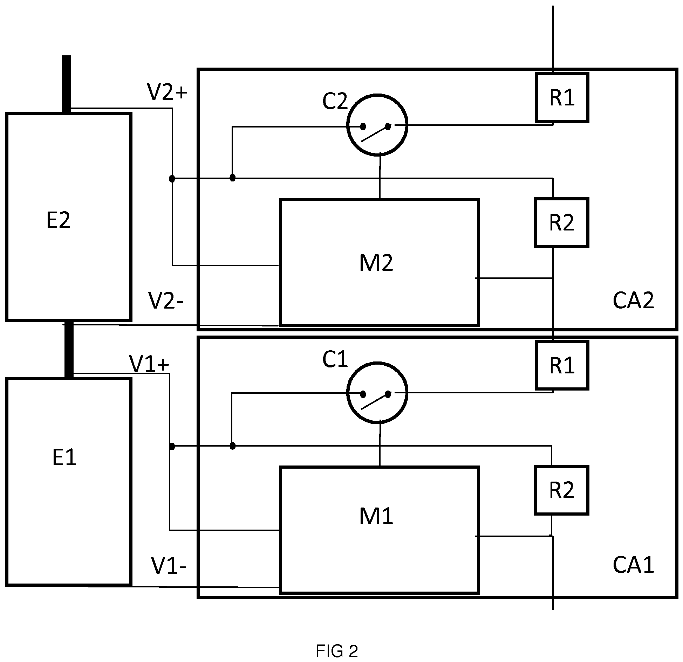

L'invention va être décrite en référence aux figures 1 et 2, respectivement selon deux modes de réalisation donnés à titre d'exemple non limitatifs.

La batterie de stockage d'énergie électrique comprend une pluralité d'éléments de stockage électriquement connectés en série entre eux. Sur les figures 1 et 2, deux éléments de stockage sont représentés et repérés E1 et E2. Il va de soi que la batterie peut comprendre un nombre d'éléments de stockage différent de deux. Chaque élément de stockage E1, E2 est constitué par une cellule électrochimique ou un module comprenant une pluralité de cellules électrochimiques assemblées entre elles. Les cellules et/ou les modules sont organisés individuellement et assemblés deux à deux de sorte notamment à atteindre un niveau de tension demandé par l'application recherchée pour la batterie.

Au sein de la batterie, pour le montage en série des éléments de stockage, deux éléments de stockage sont connectés entre eux par un élément de connexion électrique repéré B, connu sous la dénomination anglo-saxonne « busbar », formé dans un matériau électriquement conducteur. Cet élément de connexion B est fixé, par exemple par une liaison de communication vissée, tout en assurant une conduction électrique à l'emplacement de la fixation, aux deux bornes des deux éléments de stockage reliés entre eux par cet élément de connexion électrique B. Par exemple, pour les éléments de stockage E1 et E2, l'élément de connexion B qui est représenté relie la borne positive présentant le potentiel électrique noté « V1+ » de l'élément de stockage E1 à la borne négative présentant le potentiel électrique noté « V2- » de l'élément de stockage E2. Le potentiel électrique de la borne négative de l'élément de stockage E1 est noté « V1- ». Le potentiel électrique de la borne positive de l'élément de stockage E2 est noté « V2+ ». Dans le montage en série, le potentiel électrique V1- est inférieur à V1+, lui-même étant inférieur à V2-qui est inférieur à V2+. Le courant électrique qui circule dans les éléments de stockage E1, E2 circule de l'élément de stockage E1 vers l'élément de stockage E2. Le sens de circulation du courant électrique entre ces deux éléments de stockage E1, E2 dépend du fait que l'on est en charge ou en décharge.

La batterie de stockage d'énergie électrique comprend, en plus du montage en série des éléments de stockage, un système de gestion, aussi connu sous le nom de « BMS » pour « Battery Management System » en terminologie anglo-saxonne, comprenant une pluralité de cartes électroniques de contrôle. Plus précisément, une carte électronique de contrôle respective est associée à chaque élément de stockage : la carte électronique de contrôle peut par exemple permettre de déterminer la tension électrique aux bornes de l'élément de stockage qui lui est associé et/ou l'intensité électrique qui le traverse. Les cartes électroniques de contrôle comprennent chacune au moins un microcontrôleur et communiquent deux à deux via une liaison de communication de données configurée notamment de sorte à permettre un flux de données numériques entre les deux microcontrôleurs de deux cartes électroniques de contrôle différentes reliées par cette liaison de communication de données.

Ainsi, le système de gestion de la batterie comprend une carte électronique de contrôle CA1 associée à l'élément de stockage E1 et une carte électronique de contrôle CA2 associée à l'élément de stockage E2. Les cartes CA1 et CA2 comprennent chacune un microcontrôleur respectivement nommés M1 et M2 qui communiquent entre eux via une liaison de communication de données qui relie les cartes CA1 et CA2. Le potentiel électrique V1- à la borne négative de l'élément de stockage E1 est adressé à une entrée du microcontrôleur M1 de la carte électronique CA1. Le potentiel électrique V1+ à la borne positive de l'élément de stockage E1 est adressé à une autre entrée du microcontrôleur M1 de la carte électronique CA1. Le potentiel électrique V2- à la borne négative de l'élément de stockage E2 est adressé à une entrée du microcontrôleur M2 de la carte électronique CA2. Le potentiel électrique V2+ à la borne positive de l'élément de stockage E2 est adressé à une autre entrée du microcontrôleur M2 de la carte électronique CA2.

Chaque carte électronique comprend aussi au moins un commutateur (repéré respectivement C1 pour la carte électronique de contrôle CA1 et C2 pour la carte électronique de contrôle CA2) et une pluralité de résistances électriques, par exemple au moins une résistance R1 et une résistance R2 pour chaque carte électronique de contrôle CA1, CA2. La variation de position de chaque commutateur est commandée par une sortie du microcontrôleur de la même carte électronique de contrôle.

Pour chaque carte électronique de contrôle, une première entrée du commutateur de cette carte est reliée à la borne positive de l'élément de stockage associé à cette carte. Ainsi, pour la carte électronique CA1, une première entrée du commutateur C1 est reliée à la borne positive de l'élément de stockage E1. Dans la position du commutateur C1 dans laquelle le contact est établi entre sa sortie et ladite première entrée du commutateur C1, ladite sortie du commutateur C1 est en liaison électrique avec le potentiel électrique V1 +. De même, pour la carte électronique CA2, une première entrée du commutateur C2 est reliée à la borne positive de l'élément de stockage E2. Dans la position du commutateur C2 dans laquelle le contact est établi entre sa sortie et ladite première entrée du commutateur C2, ladite sortie du commutateur C2 est en liaison électrique avec le potentiel électrique V2+.

Dans le premier mode de réalisation de la figure 1, pour chaque carte électronique de contrôle, une deuxième entrée du commutateur de cette carte est reliée à la borne négative de l'élément de stockage associé à cette carte. Ainsi, pour la carte électronique CA1, une deuxième entrée du commutateur C1 est reliée à la borne négative de l'élément de stockage E1. Dans la position du commutateur C1 dans laquelle le contact est établi entre sa sortie et ladite deuxième entrée du commutateur C1, ladite sortie du commutateur C1 est en liaison électrique avec le potentiel électrique V1-. De même, pour la carte électronique CA2, une deuxième entrée du commutateur C2 est reliée à la borne négative de l'élément de stockage E2. Dans la position du commutateur C2 dans laquelle le contact est établi entre sa sortie et ladite deuxième entrée du commutateur C2, ladite sortie du commutateur C2 est en liaison électrique avec le potentiel électrique V2-.

Dans le premier mode de réalisation, chaque commutateur peut varier entre une position dans laquelle il établit le contact entre sa sortie et sa première entrée et une autre position dans laquelle il établit le contact entre sa sortie et sa deuxième entrée. On notera qu'une telle commutation permet d'effectuer une communication numérique.

Dans le deuxième mode de réalisation de la figure 2, pour chaque carte électronique de contrôle, le commutateur de cette carte ne comprend qu'une seule entrée, c'est-à-dire ladite première entrée. Chaque commutateur peut varier entre une position dans laquelle il établit le contact entre sa sortie et sa première entrée et une autre position dans laquelle il n'établit pas de contact et est traversé par un courant nul. On notera qu'ici, le potentiel est celui du point entre la résistance R1 et la résistance R2 sur la carte électronique de contrôle CA2.

Le microcontrôleur de chaque carte électronique de contrôle comprend une entrée reliée d'une part, par l'intermédiaire de la résistance R2 portée par cette carte, à la borne positive de l'élément de stockage associé à cette carte, et d'autre part, par l'intermédiaire de la résistance R1 portée par une autre carte, à la sortie du commutateur de ladite autre carte, la liaison entre cette résistance R1 et cette entrée du microcontrôleur formant concrètement la liaison de communication de données évoquée précédemment. Un tel montage a pour effet de constituer un pont diviseur de tension entre la borne positive de l'élément de stockage associé à cette carte et la sortie du commutateur de l'autre carte. Le niveau de tension noté par la suite « Vinput » adressé à cette entrée du microcontrôleur dépend donc directement de la position occupée par le commutateur de l'autre carte.

Ainsi, le microcontrôleur M2 de la carte électronique de contrôle CA2 comprend une entrée reliée d'une part, par l'intermédiaire de la résistance R2 portée par la carte CA2, à la borne positive de l'élément de stockage E2 associé à la carte CA2 (et donc en liaison avec le potentiel électrique V2+), et d'autre part, par l'intermédiaire de la résistance R1 portée par la carte CA1, à la sortie du commutateur C1 de la carte CA1, la liaison entre cette résistance R1 de la carte CA1 et cette entrée du microcontrôleur M2 formant concrètement la liaison de communication de données évoquée précédemment qui relie les cartes CA1 et CA2.

Un principe de l'invention est que la batterie de stockage d'énergie électrique comprenant d'une part au moins des premier et deuxième éléments de stockage électriquement connectés en série entre eux par un élément de connexion électrique (busbar), d'autre part au moins des première et deuxième cartes électroniques de contrôle pilotant respectivement les premier et deuxième éléments de stockage et communiquant entre elles par une liaison de communication de données de la batterie, la première carte électronique de contrôle est très avantageusement capable d'adopter une configuration dans laquelle elle transmet à la deuxième carte électronique de contrôle, par l'intermédiaire de cette liaison de communication de données, une information permettant à la deuxième carte électronique de contrôle de déterminer le potentiel électrique du point de connexion entre l'élément de connexion électrique et le premier élément de stockage. A partir de ladite information, la deuxième carte électronique de contrôle détermine la tension électrique aux bornes de l'élément de connexion électrique, entre d'une part le point de connexion entre l'élément de connexion électrique et le premier élément de stockage et d'autre part le point de connexion entre l'élément de connexion électrique et le deuxième élément de stockage. La batterie comprend alors avantageusement un élément permettant d'émettre un signal d'alerte dans le cas où ladite tension électrique est supérieure à une valeur seuil prédéterminée et enregistrée dans une mémoire.

Selon un mode de réalisation non exclusif, les première et deuxième cartes électroniques de contrôle appartiennent au système de gestion de la batterie qui est de type maître-esclaves où les première et deuxième cartes électroniques de contrôle sont deux dispositifs esclaves qui communiquent avec un dispositif maître, la communication entre les première et deuxième cartes électroniques de contrôle étant unidirectionnelle en allant de la première carte électronique de contrôle vers la deuxième carte électronique de contrôle.

Dans un premier cas d'application de l'invention aux figures 1 et 2, le premier élément de stockage est constitué par l'élément de stockage E1 et le deuxième élément de stockage est constitué par l'élément de stockage E2. La première carte électronique de contrôle est constituée par la carte électronique de contrôle CA1. La deuxième carte électronique de contrôle est constituée par la carte électronique de contrôle CA2. Les potentiels électriques V1- et V1+ aux bornes du premier élément de stockage E1 sont inférieurs aux potentiels électriques V2- et V2+ aux bornes du deuxième élément de stockage E2.

La première carte électronique de contrôle CA1 est très avantageusement capable d'adopter une configuration dans laquelle elle transmet à la deuxième carte électronique de contrôle CA2, par l'intermédiaire de la liaison de communication de données qui relie les cartes CA1 et CA2, une information permettant à la deuxième carte électronique de contrôle CA2 de déterminer le potentiel électrique V1+ du point de connexion entre l'élément de connexion électrique B qui relie les éléments de stockage E1 et E2 et le premier élément de stockage E1. A partir de cette information, la deuxième carte électronique de contrôle CA2 détermine la tension électrique aux bornes de l'élément de connexion électrique B, entre d'une part le point de connexion entre l'élément de connexion électrique B et le premier élément de stockage E1 et d'autre part le point de connexion entre l'élément de connexion électrique B et le deuxième élément de stockage E2. La batterie comprend alors avantageusement un élément permettant d'émettre un signal d'alerte dans le cas où ladite tension électrique est supérieure à une valeur seuil prédéterminée et enregistrée dans une mémoire.

Il est donc possible de faire connaître à la carte CA2, la valeur de V1 +, sur l'un des niveaux de tension d'une entrée du microcontrôleur M2 de la carte CA2 via la liaison de communication de données qui lie les cartes CA1 et CA2. La carte CA2 connaissant par ailleurs la valeur de V2-, il est possible pour le microcontrôleur M2 de déterminer la tension électrique aux bornes de l'élément de connexion B qui connecte électriquement les éléments de stockage E1 et E2.

Un autre principe veut que la batterie comporte au moins un commutateur variant entre des première et deuxième positions distinctes établissant respectivement des niveaux de tension haut et bas d'un signal électrique circulant dans la liaison de communication de données. Dans l'une des première et deuxième positions du commutateur, le niveau de tension reçu par une entrée d'un microcontrôleur de la deuxième carte électronique de contrôle dépend du potentiel électrique du point de connexion entre l'élément de connexion électrique et le premier élément de stockage. Le commutateur appartient à la première carte électronique de contrôle, mais il pourrait toutefois être implanté en dehors des première et deuxième cartes électroniques de contrôle. Il s'agit d'un commutateur piloté entre ses positions par une sortie du microcontrôleur de la carte qui porte ce commutateur.

Dans le cas d'application présent, ledit commutateur est constitué par le commutateur C1 de la carte CA1 qui est piloté par une sortie du microcontrôleur M1 qui appartient à la carte CA1. Dans l'une des deux positions du commutateur C1 de la carte CA1, le niveau de tension reçu par une entrée du microcontrôleur M2 qui appartient à la carte CA2 dépend du potentiel électrique V1+ du point de connexion entre l'élément de connexion B et le premier élément de stockage constitué ici par l'élément de stockage E1.

En référence à la figure 1, l'information qui permet à la deuxième carte électronique de contrôle CA2 de déterminer le potentiel électrique V1+ du point de connexion entre l'élément de connexion électrique B et le premier élément de stockage E1 correspond au niveau de tension reçu par l'entrée du microcontrôleur M2 de la deuxième carte électronique de contrôle CA2 dans la deuxième position du commutateur C1, ledit niveau de tension étant égal au niveau haut de tension du signal électrique circulant dans la liaison de communication de données. Cette deuxième position du commutateur C1 correspond à la position adoptée par le commutateur C1 lorsqu'il établit le contact électrique entre sa sortie et sa première entrée qui est elle-même en liaison électrique avec le potentiel électrique V1+.

Dans la première position du commutateur C1 dans laquelle il est à l'état fermé, la sortie du commutateur C1 est donc en liaison électrique avec le potentiel électrique V1-. Par contre dans la deuxième position du commutateur C1 dans laquelle il est également à l'état fermé, la sortie du commutateur C1 est en liaison électrique avec le potentiel électrique V1+.

Le niveau de tension Vinput en entrée du microcontrôleur M2 est alors, dans la deuxième position du commutateur C1, établi selon l'équation (1) suivante :

$$Vinput = V2+ \; - \; R1/(R1+R2) * (V2+ \, - \, V1+) \quad (1)$$

En admettant que R1=R2, il est possible de calculer la tension électrique notée « Ubusbar » aux bornes de l'élément de connexion électrique B, selon l'équation (2) suivante :

$$Ubusbar = 3 * (Vinput \, - \, V2-) \, - \, 2 * (V2+ \, - \, V2-) \quad (2)$$

Ainsi, à partir de l'équation (2) et de l'acquisition par le microcontrôleur M2 de Vinput, V2+ et V2- à ses trois entrées lorsque le commutateur C1 adopte sa deuxième position, le microcontrôleur M2 est capable de déterminer la tension électrique Ubusbar aux bornes de l'élément de connexion électrique B qui relie les éléments de stockage E1, E2. La batterie peut émettre un signal d'alerte dans le cas où la tension électrique Ubusbar est supérieure à une valeur seuil prédéterminée et enregistrée dans une mémoire, par exemple implantée dans le dispositif maître du système de gestion avec qui communiquent toutes les cartes électroniques de contrôle.

On notera que dans ce calcul, R1=R2 est un simple exemple, en effet ce calcul peut être fait avec toute valeur de R1 et R2.

En référence à la figure 2 maintenant, l'information qui permet à la deuxième carte électronique de contrôle CA2 de déterminer le potentiel électrique du point de connexion entre l'élément de connexion électrique B et le premier élément de stockage E1 correspond au niveau de tension reçu par l'entrée du microcontrôleur M2 de la deuxième carte électronique de contrôle CA2 dans la première position du commutateur C1, ledit niveau de tension étant égal au niveau bas de tension du signal électrique circulant dans la liaison de communication de données. Cette première position du commutateur C1 correspond à la position adoptée par le commutateur C1 lorsqu'il établit le contact électrique entre sa sortie et son entrée qui est elle-même en liaison électrique avec le potentiel électrique V1+.

Dans la deuxième position du commutateur C1 sur la figure 2, le commutateur C1 est ouvert et le niveau de tension Vinput à l'entrée du microcontrôleur M2 ne dépend pas du potentiel électrique V1-. Par contre dans la première position du commutateur C1 dans laquelle il est à l'état fermé, la sortie du commutateur C1 est en liaison électrique avec le potentiel électrique V1 +. L'équation (1) est vérifiée lorsque le commutateur C1 adopte sa première position.

Ainsi, une fois encore, à partir de l'équation (2) et de l'acquisition par le microcontrôleur M2 de Vinput dans la première position du commutateur C1, de V2+ et de V2- à ses trois entrées, le microcontrôleur M2 est capable de déterminer la tension électrique Ubusbar aux bornes de l'élément de connexion électrique B qui relie les éléments de stockage E1, E2. La batterie peut émettre un signal d'alerte dans le cas où la tension électrique Ubusbar est supérieure à une valeur seuil prédéterminée et enregistrée dans une mémoire, par exemple implantée dans le dispositif maître du système de gestion avec qui communiquent toutes les cartes électroniques de contrôle.

La première carte électronique de contrôle CA2 est très avantageusement capable d'adopter une configuration dans laquelle elle transmet à la deuxième carte électronique de contrôle CA1, par l'intermédiaire de la liaison de communication de données qui relie les cartes CA1 et CA2, une information permettant à la deuxième carte électronique de contrôle CA1 de déterminer le potentiel électrique V2- du point de connexion entre l'élément de connexion électrique B qui relie E1 et E2 et le premier élément de stockage E2. A partir de cette information, la deuxième carte électronique de contrôle CA1 détermine la tension électrique aux bornes de l'élément de connexion électrique B, entre d'une part le point de connexion entre l'élément de connexion électrique B et le premier élément de stockage E2 et d'autre part le point de connexion entre l'élément de connexion électrique B et le deuxième élément de stockage E1. La batterie comprend alors avantageusement un élément permettant d'émettre un signal d'alerte dans le cas où ladite tension électrique est supérieure à une valeur seuil prédéterminée et enregistrée dans une mémoire.

Il est possible de faire connaître à la carte CA1, la valeur de V2-, sur l'un des niveaux de tension d'une entrée du microcontrôleur M1 via la liaison de données qui lie les cartes CA1 et CA2. La carte CA1 connaissant par ailleurs la valeur de V1+, il est possible pour le microcontrôleur M1 de déterminer la tension électrique aux bornes de l'élément de connexion B qui connecte électriquement les éléments de stockage E1 et E2.

Dans le cas d'application présent, le commutateur qui permet la mise en oeuvre de l'invention est constitué par le commutateur C2 de la carte CA2 qui est piloté par une sortie du microcontrôleur M2 qui appartient à la carte CA2. Dans l'une des deux positions du commutateur C2 de la carte CA2, le niveau de tension reçu par une entrée du microcontrôleur M1 qui appartient à la carte CA1 dépend du potentiel électrique V2- du point de connexion entre l'élément de connexion B et le premier élément de stockage constitué ici par l'élément de stockage E2.

L'invention précédemment décrite permet bien d'atteindre les objets précédemment évoqués et présente l'avantage supplémentaire de permettre de faire passer dans le fil de communication de données qui relie les cartes électroniques de type « esclave » à la fois le flux numérique et la valeur analogique de la tension en amont du busbar. L'un des deux niveaux de la communication numérique est lié au potentiel électrique de la connexion entre le busbar et l'élément de stockage correspondant.

**Revendications**

1. Batterie de stockage d'énergie électrique, comprenant d'une part au moins des premier et deuxième éléments de stockage (E1, E2) électriquement connectés en série entre eux par un élément de connexion électrique (B), d'autre part au moins des première et deuxième cartes électroniques de contrôle (CA1, CA2) pilotant respectivement les premier et deuxième éléments de stockage et communiquant entre elles par une liaison de communication de données, la batterie étant **caractérisée en ce que** la première carte électronique de contrôle est configurée pour transmettre à la deuxième carte électronique de contrôle, par l'intermédiaire de la liaison de communication de données, une information permettant à la deuxième carte électronique de contrôle de déterminer le potentiel électrique (V1+, V2-) du point de connexion entre l'élément de connexion électrique et le premier élément de stockage, de manière à déduire la tension électrique (Ubusbar) aux bornes de l'élément de connexion électrique, entre d'une part le point de connexion entre l'élément de connexion électrique et le premier élément de stockage et d'autre part le point de connexion entre l'élément de connexion électrique et le deuxième élément de stockage.

2. Batterie de stockage d'énergie électrique selon la revendication 1, **caractérisée en ce qu'**elle comporte au moins un commutateur (C1, C2) variant entre des première et deuxième positions distinctes établissant respectivement des niveaux de tension haut et bas d'un signal électrique circulant dans la liaison de communication de données et **en ce que** dans l'une des première et deuxième positions du commutateur, le niveau de tension reçu par une entrée d'un microcontrôleur (M1, M2) de la deuxième carte électronique de contrôle dépend du potentiel électrique du point de connexion entre l'élément de connexion électrique et le premier élément de stockage.

3. Batterie de stockage d'énergie électrique selon la revendication 2, **caractérisée en ce que** le commutateur appartient à la première carte électronique de contrôle.

4. Batterie de stockage d'énergie électrique selon l'une des revendications 2 ou 3, **caractérisée en ce que** l'information qui permet à la deuxième carte électronique de contrôle de déterminer le potentiel électrique du point de connexion entre l'élément de connexion électrique et le premier élément de stockage correspond au niveau de tension reçu par l'entrée du microcontrôleur de la deuxième carte électronique de contrôle dans la première position du commutateur, ledit niveau de tension étant égal au niveau bas de tension du signal électrique circulant dans la liaison de communication de données.

5. Batterie de stockage d'énergie électrique selon l'une des revendications 2 ou 3, **caractérisée en ce que** l'information qui permet à la deuxième carte électronique de contrôle de déterminer le potentiel électrique du point de connexion entre l'élément de connexion électrique et le premier élément de stockage correspond au niveau de tension reçu par l'entrée du microcontrôleur de la deuxième carte électronique de contrôle dans la deuxième position du commutateur, ledit niveau de tension étant égal au niveau haut de tension du signal électrique circulant dans la liaison de communication de données.

6. Batterie de stockage d'énergie électrique selon l'une des revendications 1 à 5, **caractérisée en ce que** les première et deuxième cartes électroniques de contrôle appartiennent à un système de gestion de la batterie de type maître-esclaves où les première et deuxième cartes électroniques de contrôle sont deux dispositifs esclaves qui communiquent avec un dispositif maître, la communication entre les première et deuxième cartes électroniques de contrôle étant unidirectionnelle en allant de la première carte électronique de contrôle vers la deuxième carte électronique de contrôle.

7. Batterie de stockage d'énergie électrique selon l'une des revendications 1 à 6, **caractérisée en ce qu'**elle comprend un élément permettant d'émettre un signal d'alerte dans le cas où ladite tension électrique est supérieure à une valeur seuil prédéterminée et enregistrée dans une mémoire.

**Patentansprüche**

1. Speicherbatterie elektrischer Energie, die einerseits mindestens erste und zweite Speicherelemente (E1, E2), die durch ein elektrisches Verbindungselement (B) in Reihe miteinander verbunden sind, andererseits mindestens erste und zweite elektronische Steuerkarten (CA1, CA2) enthält, die je die ersten und zweiten Speicherelemente steuern und über eine Datenkommunikationsverbindung miteinander kommunizieren, wobei die Batterie **dadurch gekennzeichnet ist, dass** die erste elektronische Steuerkarte konfiguriert ist, mittels der Datenkommunikationsverbindung eine Information an die zweite elektronische Steuerkarte zu übertragen, die es der zweiten elektronischen Steuerkarte ermöglicht, das elektrische Potential (V1+, V2-) des Verbindungspunkts zwischen dem elektrischen Verbindungselement und dem ersten Speicherelement zu bestimmen, um die elektrische Spannung (Ubusbar) an den Klemmen des elektrischen Verbindungselements zwischen einerseits dem Verbindungspunkt zwischen dem elektrischen Verbindungselement und dem ersten Speicherelement und andererseits dem Verbindungspunkt zwischen dem elektrischen Verbindungselement und dem zweiten Speicherelement abzuleiten.

2. Speicherbatterie elektrischer Energie nach Anspruch 1, **dadurch gekennzeichnet, dass** sie mindestens einen Schalter (C1, C2) aufweist, der zwischen ersten und zweiten unterschiedlichen Stellungen variiert, die je hohe und niedrige Spannungspegel eines elektrischen Signals aufbauen, das in der Datenkommunikationsverbindung zirkuliert, und dass in einer der ersten und zweiten Stellungen des Schalters der von einem Eingang eines Mikrocontrollers (M1, M2) der zweiten elektronischen Steuerkarte empfangene Spannungspegel vom elektrischen Potential des Verbindungspunkts zwischen dem elektrischen Verbindungselement und dem ersten Speicherelement abhängt.

3. Speicherbatterie elektrischer Energie nach Anspruch 2, **dadurch gekennzeichnet, dass** der Schalter zur ersten elektronischen Steuerkarte gehört.

4. Speicherbatterie elektrischer Energie nach einem der Ansprüche 2 oder 3, **dadurch gekennzeichnet, dass** die Information, die es der zweiten elektronischen Steuerkarte ermöglicht, das elektrische Potential des Verbindungspunkts zwischen dem elektrischen Verbindungselement und dem ersten Speicherelement zu bestimmen, dem vom Eingang des Mikrocontrollers der zweiten elektronischen Steuerkarte in der ersten Stellung des Schalters empfangenen Spannungspegel entspricht, wobei der Spannungspegel gleich dem niedrigen Spannungspegel des in der Datenkommunikationsverbindung zirkulierenden elektrischen Signal ist.

5. Speicherbatterie elektrischer Energie nach einem der Ansprüche 2 oder 3, **dadurch gekennzeichnet, dass** die Information, die es der zweiten elektronischen Steuerkarte ermöglicht, das elektrische Potential des Verbindungspunkts zwischen dem elektrischen Verbindungselement und dem ersten Speicherelement zu bestimmen, dem vom Eingang des Mikrocontrollers der zweiten elektronischen Steuerkarte in der zweiten Stellung des Schalters empfangenen Spannungspegel entspricht, wobei der Spannungspegel gleich dem hohen Spannungspegel des in der Datenkommunikationsverbindung zirkulierenden elektrischen Signals ist.

6. Speicherbatterie elektrischer Energie nach einem der Ansprüche 1 bis 5, **dadurch gekennzeichnet, dass** die ersten und zweiten elektronischen Steuerkarten zu einem Verwaltungssystem der Batterie der Art Master-Slave gehören, bei dem die ersten und zweiten elektronischen Steuerkarten zwei Slave-Vorrichtungen sind, die mit einer Master-Vorrichtung kommunizieren, wobei die Kommunikation zwischen den ersten und zweiten elektronischen Steuerkarten unidirektional ist und von der ersten elektronischen Steuerkarte zur zweiten elektronischen Steuerkarte geht.

7.  Speicherbatterie elektrischer Energie nach einem der Ansprüche 1 bis 6, **dadurch gekennzeichnet, dass** sie ein Element enthält, das es ermöglicht, in dem Fall ein Warnsignal auszugeben, in dem die elektrische Spannung höher als ein vorbestimmter und in einem Speicher gespeicherter Sollwert ist.

**Claims**

1.  Electrical energy storage battery comprising, on the one hand, at least first and second storage elements (E1, E2) that are electrically connected in series with one another by an electrical connection element (B) and, on the other hand, at least first and second control circuit boards (CA1, CA2) driving, respectively, the first and second storage elements and communicating with one another via a data communication link, the battery being **characterized in that** the first control circuit board is configured to transmit, to the second control circuit board, via the data communication link, information allowing the second control circuit board to determine the electrical potential (V1+, V2-) of the connection point between the electrical connection element and the first storage element, so as to deduce the voltage (Ubusbar) across the terminals of the electrical connection element between, on the one hand, the connection point between the electrical connection element and the first storage element and, on the other hand, the connection point between the electrical connection element and the second storage element.

2.  Electrical energy storage battery according to Claim 1, **characterized in that** it comprises at least one switch (C1, C2) varying between first and second distinct positions establishing, respectively, high and low voltage levels of an electrical signal flowing through the data communication link and **in that** in one of the first and second positions of the switch, the voltage level received by an input of a microcontroller (M1, M2) of the second control circuit board depends on the electrical potential of the connection point between the electrical connection element and the first storage element.

3.  Electrical energy storage battery according to Claim 2, **characterized in that** the switch belongs to the first control circuit board.

4.  Electrical energy storage battery according to one of Claims 2 and 3, **characterized in that** the information that allows the second control circuit board to determine the electrical potential of the connection point between the electrical connection element and the first storage element corresponds to the voltage level received by the input of the microcontroller of the second control circuit board in the first position of the switch, said voltage level being equal to the low voltage level of the electrical signal flowing through the data communication link.

5.  Electrical energy storage battery according to one of Claims 2 and 3, **characterized in that** the information that allows the second control circuit board to determine the electrical potential of the connection point between the electrical connection element and the first storage element corresponds to the voltage level received by the input of the microcontroller of the second control circuit board in the second position of the switch, said voltage level being equal to the high voltage level of the electrical signal flowing through the data communication link.

6.  Electrical energy storage battery according to one of Claims 1 to 5, **characterized in that** the first and second control circuit boards belong to a master/minion-type battery management system where the first and second control circuit boards are two minion devices which communicate with a master device, the communication between the first and second control circuit boards being unidirectional and going from the first control circuit board to the second control circuit board.

7.  Electrical energy storage battery according to one of Claims 1 to 6, **characterized in that** it comprises an element allowing an alert signal to be issued in the event that the said voltage is higher than a predetermined threshold value stored in a memory.

FIG 1

FIG 2

**EP 3 341 985 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012237807 A1

- FR 2940547 A1